# EUROPEAN PATENT SPECIFICATION

(11) **EP 1 353 541 B1**
(45) Date of publication and mention of the grant of the patent: **07.05.2008**
(21) Application number: 02729552.6
(22) Date of filing: 11.01.2002
(51) Int. Cl.: H05K 3/46

(54) **CIRCUIT BOARD AND PRODUCTION METHOD THEREFOR**
LEITERPLATTE UND VERFAHREN ZU IHRER HERSTELLUNG
CARTE DE CIRCUIT IMPRIME ET SON PROCEDE DE FABRICATION

(30) Priority: 16.01.2001 JP 2001007338
(43) Date of publication of application: 15.10.2003
(73) Proprietor: MATSUSHITA ELECTRIC INDUSTRIAL CO., LTD, Kadoma-shi, Osaka 571-8501 (JP)
(72) Inventor: NISHII, Toshihiro, Hirakata-shi, Osaka 573-0163 (JP)
(74) Representative: Grünecker, Kinkeldey, Stockmair & Schwanhäusser Anwaltssozietät
(86) International application number: PCT/JP2002/000133
(87) International publication number: WO 2002/056655

(56) References cited:
- EP-A- 0 449 292
- EP-A- 0 645 950
- EP-A- 0 755 979
- EP-A- 1 030 544
- EP-A1- 0 645 950
- JP-A- 8 316 598
- US-A- 5 284 548
- US-A- 5 837 155
- US-A- 6 127 634

## Description

### TECHNICAL FIELD

The present invention relates to circuit boards used in various electronic equipment and a method of manufacturing the same.

### BACKGROUND ART

With a recent trend of reduction in size and increase in density of electronic equipment, double-sided wiring boards and multi-layer wiring boards are increasingly employed in place of conventional single-sided wiring boards on which electronic components are mounted. Also, high-density circuit boards capable of mounting as many circuits as possible thereon are positively developed.

As for a high-density circuit board, in place of a conventional method that has been widely employed for forming through-holes (via-holes) in a wiring board by drilling and making interstitial connection of wiring by metal-plating, a method of manufacturing a circuit board having inner-via-hole structure capable of interstitial connection of wiring at the specified position in higher density has been developed (for example, the May number, 1996, of "Surface Mounting Technology" published by Nikkan Kogyo Shinbun; "Resin based multi-layer circuit board ALIVH and its Application" by Masa Tachibana et al.; and Japanese Laid-open Patent H6-268345).

In such newly developed wiring board having inner-via-hole structure, a method of filling conductive paste into the holes formed between the layers of wiring or a method of metal-plating the inner walls of the holes is employed in order to make the interstitial connection between the layers of wiring.

One of the methods available for making interstitial connection between the layers of wiring by using conductive paste comprises a hot pressing process in which a board material filled with conductive paste is laminated with copper foils or the like and integrated therewith under heat and pressure. In the laminating process by a hot pressing process, the board material is desirably compressed in the direction of thickness so that the conductive paste and copper foil or the like are securely bonded to each other. As a material which is easily compressed, for example, a material made by impregnating non-woven fabric such as aramid fiber or the like with epoxy resin and made B staged has been developed.

Non-woven fabric is preferable as a material which is easily controlled a flow resistance when fluid flows in the fabric.

However, since a higher-density circuit board is smaller in the wire width of wirings and the size of lands, it is important to ensure the adhesion between the board material and the wirings or the lands in order to assure the reliability of circuit board.

Particularly, in the case of recent portable electronic equipment such as cellular phones, mobile information terminals, and notebook personal computers, mechanical stresses are liable to be applied to the circuit board with electronic components mounted thereon. If the lands on which electronic components are mounted by soldering or the like are not sufficiently bonded to the board material, the lands will peel off from the circuit board, resulting in a problem of circuit breakdown or the like.

Also, in a board material using non-woven fabric which is easily controlled the compression as described above, the fibers are irregularly placed, and, therefore, when a stress in a direction of peeling is applied to the lands or wirings on the circuit board, a peeling phenomenon due to internal damage occurs because a bonding between the fibers is insufficient.

Further, an organic material, aramid fiber in particular, is sometimes used as non-woven fabric material because it is easily processed by a laser beam for drilling the board material. In this case, the bonding between the non-woven fabric and impregnated resin becomes sometimes insufficient, which results in a weak bonding against stresses in the direction of peeling.

A method of manufacturing conventional circuit board, also used in EP 0 645 950 B1, will be described with reference to Fig. 3A to Fig. 3I.

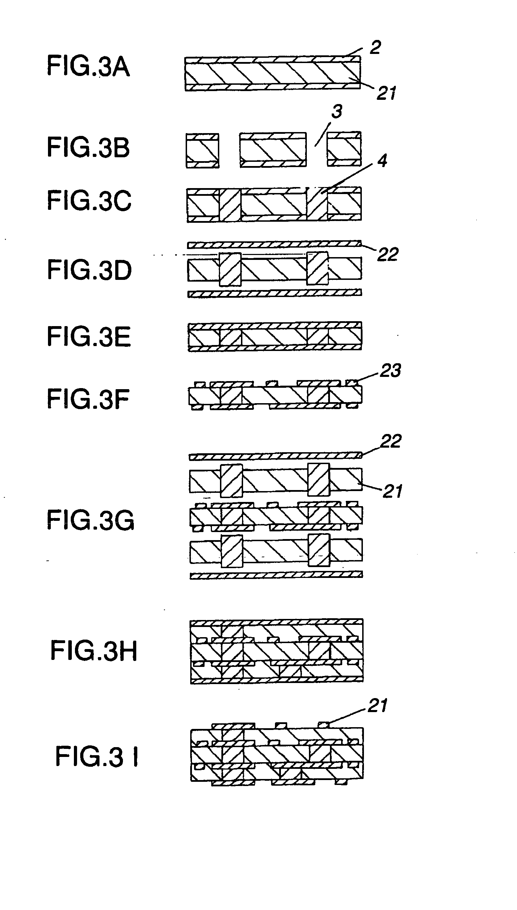

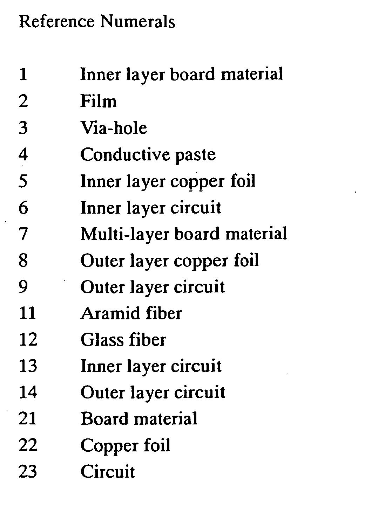

First, as shown in Fig. 3A, a material with polyethylene terephthalate based films 2 temporarily bonded to both sides of board material 21 by a hot lamination process is prepared.

The board material 21 is a B staged prepreg sheet made by impregnating aramid fiber non-woven fabric with epoxy resin and hot-air drying (at 100 °C to 150 °C for about 5 minutes).

An example of aramid fiber non-woven fabric is non-woven fabric of about 110 µm in thickness prepared by a wet-type sheet making process mainly using para-aromatic polyamid fiber (du Pon't & "Kebler"), which is treated under a heat and pressure by a hot roll, followed by a heat treatment (at about 250 °C for 30 minutes).

As epoxy resin to be impregnated, for example, a resin mixture of brominated bisphenol A type epoxy resin and thee-functional epoxy resin is used, which is made to be a varnish-like resin, using a hardener and a solvent such as methyl ethyl ketone.

Next, as shown in Fig 3B, via-holes 3 of about 150 µm in diameter are formed by a laser beam process. By the material composition as described above, it is possible to obtain a favorable hole shape using a carbon dioxide laser or a YAG laser harmonics.

Next, as shown in Fig. 3C, conductive paste 4 is filled into via-holes 3 by using a printing means such as squeegee.

Next, the films 2 are removed from the board material 21, making the conductive paste 4 protruding from the board material 21 for about a thickness of the film 2, and the board material 21 is placed between copper foils 22 as shown in Fig. 3D.

The board material 21 is compressed under heat and pressure using a hot press to obtain a copper-clad laminate shown in Fig. 3E. Under the press condition, the copper foils 22 are bonded to the board material 21, and then the impregnated resin of board material 21 cures.

Further, the copper foils 22 on a surface and a back surface are electrically connected to each other by the conductive paste 4. Before and after the treatment under heat and pressure, the board material 21 is compressed from a thickness of about 130 µm to a thickness of about 110 µm.

During the treatment, the resin impregnated in the board material 21 flows out to the right and left of board material 21, and the amount of compression and a quantity of conductive paste 4 protruding from the board material 21, shown in Fig. 3D, are an important factor relating to a quality of an electrical connection.

Next, as shown in Fig. 3F, copper foils 22 are patterned (circuit forming) by a method such as etching in to obtain a double-sided circuit board having circuits 23 on both sides thereof.

Next, the board materials 21 with conductive paste 4 filled and the copper foils 22 are placed on both sides of the double-sided circuit board as shown in Fig. 3G, and is processed under heat and pressure to make a laminated circuit board as shown in Fig. 3H. Further, by etching the copper foils 22 on the surfaces to form circuits thereon, a circuit board having a four-layer structure can be obtained as shown in Fig. 3I.

However, the above conventional circuit board and the circuit board manufacturing method involve the following problems.

That is, since the non-woven fabric is used for board material 21, it is possible to properly control the flow of impregnated resin during operation under heat and pressure and, as a result, to realize appropriate electrical interstitial connection between the layers of wiring, but the adhesion is not always enough between circuit 23 and board material 21.

In the examination executed by the inventor, although it depends upon the process conditions and the material composition of the impregnated resin, the result obtained in the peeling test of copper foil of 1 cm in width by pulling vertically against the board material is only 10 N at max.

This value is not always enough to obtain sufficient connection reliability when circuit 23 of fine width is formed or when circuit 23 is used as a land for soldering electronic components thereon.

Also, in the case of using non-woven fabric for board material 21 to be described later, it is possible to ensure the adhesion of circuits against the board material, but it is difficult to control the quantity of the impregnated resin flowing during the operation under heat and pressure. As a result, conductive paste 4 is forced to run out due to the flow of impregnated resin during the operation under heat and pressure, which sometimes cause a problem of losing the stability of interstitial connection resistance between the layers of wiring.

If the fluidity of impregnated resin is lowered to prevent the conductive paste 4 from being forced to run out, the compression in the direction of thickness of the board material 21 during the operation under heat and pressure becomes decreased, and there arises a problem that a stable electrical interstitial connection between the layers of wiring cannot be obtained.

Further, in case glass fiber is used for the reinforcement of board material 21, it is liable to cause variations in diameter of holes when via-holes 3 are formed by a laser process, resulting in unstable interstitial connection between the layers of wiring.

### DISCLOSURE OF THE INVENTION

The above mentioned problems are solved by the features of the independent claims.

According to the present invention, the quality of the interstitial electrical connection, for example, in the inner layer circuit board can be stabilized

Also, in method of manufacturing the circuit board the present invention, since the multi-layer board material and the inner layer board material used in the manufacturing process are different in material from each other, it is possible to set the hot pressing condition or the like in a relatively wide range in the laminating step. Accordingly, it is possible to improve the circuit board quality and reliability, and to reduce the cost.

### BRIEF DESCRIPTION OF THE DRAWINGS

Fig. 1A to Fig. 1I are sectional views showing a method of manufacturing circuit board in the preferred embodiment of the present invention.
Fig. 2A to Fig. 2E are sectional views showing a board material in the preferred embodiment of the present invention.
Fig. 3A to Fig. 3I are sectional views showing a conventional method of manufacturing circuit board.

### DETAILED DESCRIPTION OF PREFERRED EMBODIMENTS

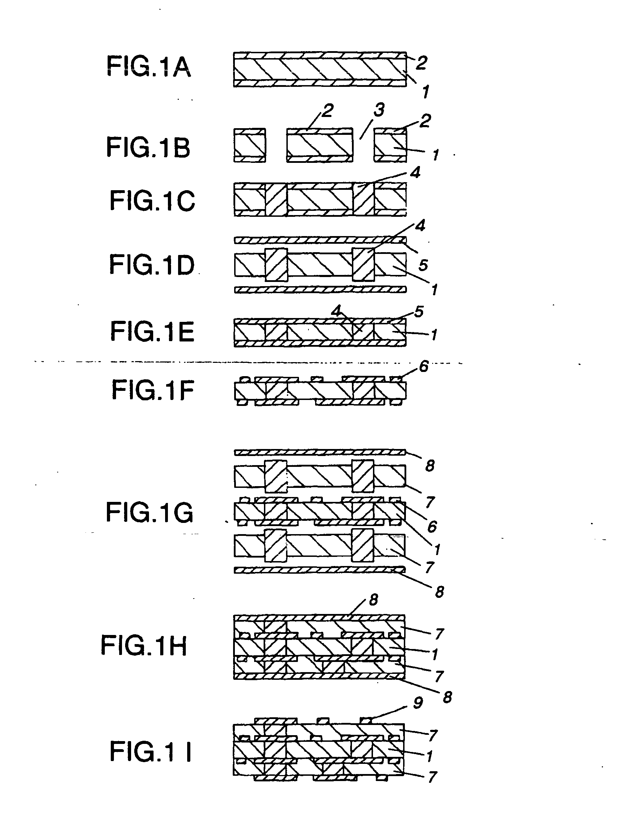

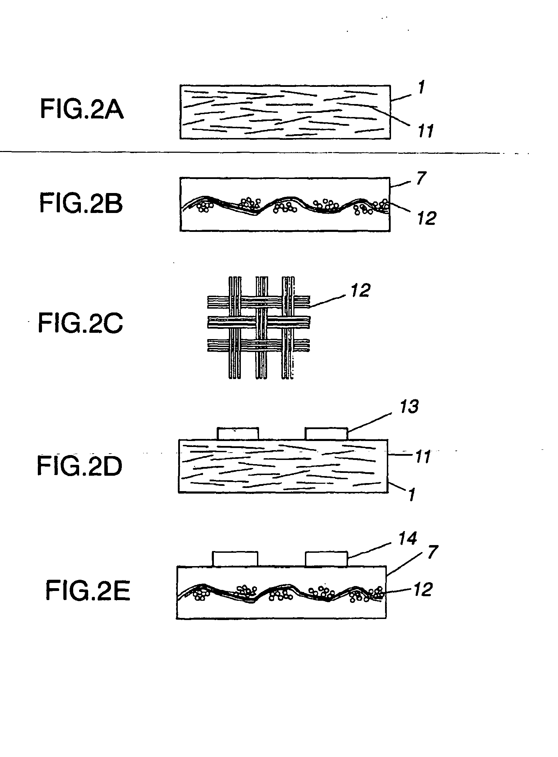

The preferred embodiments of the present invention will be described in the following with reference to Fig. 1A to Fig. 1I and Fig. 2A to Fig. 2E. Fig. 1A to Fig. 1I are sectional views showing a method of manufacturing circuit board in the preferred embodiment of the present invention.

First, as shown in Fig. 1A, a prepreg sheet having aramid fiber non-woven fabric impregnated with epoxy resin and temporarily bonded with films 2 based on polyethylene phthalate by a laminating process using a hot roll onto both sides of an inner layer board material 1 is prepared.

Next, as shown in Fig. 1B, via-holes 3 of about 150 µm in diameter are formed by a laser beam or the like process. In the case of this preferred embodiment, a proper hole shape can be formed by using a carbon dioxide layer or a YAG laser harmonics. The hole forming means is not limited to the laser beam process mentioned above, but it is also possible to use a drill as in a conventional method.

Next, as shown in Fig. 1C, conductive paste 4 is filled into via-holes 3 by using a squeegee or the like. An example of preferable conductive paste 4 is prepared by dispersing copper-based conductive particles into a binder component consisting of epoxy resin that is thermosetting resin, hardener, organic solvents, and dispersing agents.

The hardener, organic solvents, non-conductive particles, and dispersing agents can be properly added as additives when necessary.

As an example of conductive paste composition in the present preferred embodiment, bisphenol-A type epoxy resin as epoxy resin, amine adduct hardener as hardener, high boiling point solvent such as butyl carbitol acetate as solvent, and phosphoric acid ester type surface active agent as dispersing agent can be used.

Next, the film 2 is peeled off from the board material 1, making the conductive paste 4 protrude from the inner layer board material 1 for about a thickness of the film 2, and the board material 1 is disposed between inner layer copper foils 5 as shown in Fig. 1D

Then, the inner layer board material 1 is compressed under heat and pressure by means of a hot press. As shown in Fig. 1E, the inner layer copper foils 5 are bonded to the inner layer board material 1, and the impregnated resin of inner layer board material 1cures. Further, the inner layer copper foils 5 on a surface and on a back surface are electrically connected to each other by the conductive paste 4.

Before and after the pressing under heat and pressure, the inner layer board material 1 is compressed from a thickness of about 130 µm to a thickness of about 110 µm.

At this time, the resin impregnated in the inner layer board material 1 flows out to a right and left direction of the inner layer board material 1, and the amount of compression and a quantity of conductive paste 4 protruding from the inner layer board material 1, as shown in Fig. 1D, are closely related with the quality of electrical connection.

Next, the inner layer copper foils 5 are patterned by a method such as an etching to obtain a double-sided circuit board having inner layer circuits 6 on either side thereof as shown in Fig. IF.

And, multi-layer board materials 7 with conductive paste 4 filled and outer layer copper foils 8 are disposed on both sides of the double-sided circuit board as shown in Fig. 1G, and are pressed under heat and pressure to make a laminated circuit board as shown in Fig. 1H. Further, by etching the outer layer copper foils 8 on both surfaces to form outer layer circuits 9, a circuit board having a four-layer structure can be obtained as shown in Fig. 1I.

Next, the inner layer board material 1 and the multi-layer board material 7 in the present preferred embodiment will be described with reference to Fig. 2A to Fig. 2E.

As an example of the inner layer board material 1, a sheet-form resin material including non cured component can be used. The inner layer board material 1 more preferably comprises a composite material including inorganic or organic reinforcing materials and thermosetting resin.

Fig. 2A shows an example of the inner layer board material 1, which uses B staged prepreg by impregnating non-woven fabric made of aramid fiber 11 with epoxy resin and hot-air drying (at 100 °C - 150 °C for about 5 minutes).

An example of the aramid fiber non-woven fabric is a non-woven fabric sheet mainly consisting para-type aromatic polyamid fiber (du Pont's "Kebler"), which is prepared by a wet-type sheet making process and treated under heat and pressure by means of a hot roll, followed by a heat treatment (at about 250 °C for 30 minutes). Also, other types of aromatic aramid fiber or heat resisting fiber can be used as the non-woven fabric material.

As the epoxy resin, for example, a resin mixture of brominated bisphenol-A type epoxy resin and thee-functional epoxy resin can be used. The resin is made to a varnish-like resin, by adding a hardener and a solvent such as methyl ethyl ketone, and is impregnated into the aramid fiber non-woven fabric and then dried in hot air. The board material 1 (prepreg) after drying includes 52 wt % of resin impregnated, and is 120 µm in thickness.

As shown in Fig. 2A, aramid fiber 11 is almost uniformly distributed in the inner layer board material 1. This is because the non-woven fabric is impregnated with the resin solution in a manner such that the resin solution is absorbed when the non-woven fabric is impregnated with the resin solution which is decreased in viscosity by a solvent or the like.

In the case of such inner layer board material 1, when the board is pressed in the vertical direction under heat and pressure, the molten resin faces increased flow resistance when flowing horizontally. Accordingly, as described in the present preferred embodiment, the conductive paste 4 is hard to flow out of the via-holes 3, and the compression of conductive paste 4 is effectively performed to obtain stable interstitial electrical connection by the conductive paste 4. The aramid fiber 11 as reinforcing material is small in specific gravity and ensures good workability in drilling by a laser beam, and is therefore a preferable material.

However, as shown in Fig. 2D, there exists the aramid fiber 11 just underneath inner layer circuit 13 when the inner layer circuit 13 is bonded to the inner layer board material 1. Consequently, the aramid fiber 11 is not sufficiently bonded to the resin impregnated in the inner layer board material 1, and in case a peeling stress is applied to the inner layer circuit 13, a peeling may occur at an interface between the aramid fiber 11 and impregnated resin. As a result, a breakdown occurs in the inner layer board material 1 while the impregnated resin and aramid fiber 11 are bonded to the inner layer circuit 13, that is, the circuit 13 is peeled off from the inner layer board material 1 with a relatively weak force due to a so-called bulk breakdown mode.

In other words, there arises a problem of insufficient adhesive strength of the inner layer circuit 13. Aramid fiber 11 is a material relatively difficult in bonding to resin material, which is liable to invite a problem as mentioned above.

Also, there arises a similar problem when glass fiber is used. Accordingly, as a common method, the fiber surfaces are treated by a corona or a plasma processing, or an adhesion property is improved by using a silane coupling agent. However, the effects obtained by such method are not sufficient enough in recent high-density circuit boards.

Fig. 2B shows an example of multi-layer board material in the present invention. As the multi-layer board material, a sheet-form resin material including non-cured component can be used. It is more preferable to employ a composite materials including inorganic or organic reinforcing materials and thermosetting resin.

The present invention is characterized in that a material suited for inner circuit board is selected for the inner layer board material 1 and that a material suited for the board material for multi-layer circuit board is used for the multi-layer board material 7. Accordingly, in the present preferred embodiment, the inner layer board material 1 and the multi-layer board material 7 are different in composition from each other.

As an example of reinforcing material for the multi-layer board material 7 shown in Fig. 2B, glass fiber 12 of E-glass of 4.6 microns in filament diameter and twisted 4.4 times per inch is used in the form of woven fabric as shown in Fig. 2C.

As for thermosetting resin, Shell EPON 1151 B 60 having a glass transition temperature of 180 °C is used as epoxy resin. This resin is diluted, using methyl ethyl ketone (MEK) as a solvent, for the purpose of resin impregnation, and dried to obtain a prepreg. The quantity of resin after drying is about 30 wt % against glass fiber 12, and a thickness of the prepreg after drying is about 120 µm.

In such multi-layer board material 7, as shown in Fig. 2B, resin layer is formed on top and bottom of the woven fabric of glass fiber 12. This is because the woven fabric, unlike the non-woven fabric, does not absorb the resin when impregnated with resin decreased in viscosity by solvent or the like. A few of the impregnated resin permeates into the woven fabric, and most of the resin forms resin layers on top and bottom of the woven fabric.

In the case of the multi-layer board material 7 having above configuration, when the board is pressed under heat and pressure in the vertical direction, the resin faces less flow resistance when melted and flowing horizontally. That is, the resin on top and bottom of the woven fabric is free of fiber obstructive to the flow and easier to move horizontally.

Accordingly, conductive paste 4 may sometimes flow out of the via-hole 3, and the conductive paste 4 is not effectively compressed in the direction of board material thickness. Then, the interstitial electrical connection by the conductive paste 4 may sometimes become unstable.

In other words, it can be said that the inner layer board material 1 is advantageous with respect to interstitial electrical connection by conductive paste 4. Further, glass fiber 12 is rather difficult to be drilled by a laser beam, and due to variations in hole diameter, the interstitial electrical connection resistance may sometimes become unstable.

However, as shown in Fig. 2E, in case outer layer circuit 14 is bonded to the multi-layer board material 7, unlike the case of Fig. 2D, the resin layer is located just underneath the outer layer circuit 14. Thus, bulk breakdown is hard to occur in the multi-layer board material 7 because no glass fiber 12 exists. Since glass fiber 12 is woven into the woven fabric, there is less chance of peeling off of the fibers from each other. Accordingly, the adhesive strength of outer layer circuit 14 to the board material is increased, and the outer layer circuit 14 does not peel off from the board material even when a considerable peeling stress is applied.

As described above, the inner layer board material 1 and the multi-layer board material 7 are different in features from each other. The features will be described with respect to the circuit board shown in Fig. 1.

In a double-sided circuit board, or an inner layer circuit board, the compression of conductive paste 4 can be obtained according to the amount of the conductive paste 4 protruding from the inner layer board material 1 as shown in Fig. 1D, and the compression of the inner layer board material 1 under heat and pressure in the direction of thickness. Therefore, it is necessary to employ a board material which may ensure high compression efficiency of conductive paste 4.

On the other hand, as is obvious from the four-layer circuit board shown in Fig. 1I, inner layer circuit 6 is protected by the outer layer board material 7 at the outside, and there is a little possibility of direct application of stress to the inner layer circuit 6 in a peeling direction. Accordingly, the inner layer board material 1 using aramid fiber non-woven fabric mentioned above is more preferable for the inner layer circuit board.

Also, in multi-layer board material 7, as shown in Fig. 1G, since conductive paste 4 is placed and laminated on the protruded inner layer circuit 6, the amount of compression of conductive paste 4 becomes greater than that of the inner layer board material shown in Fig. 1D for a thickness of the inner layer circuit 6. Accordingly, the conductive paste 4 is properly compressed when laminated, and thereby, interstitial connection of excellent stability is obtained.

However, as is seen in Fig. 1I, since the outer layer circuit 9 is located on the outermost layer of the circuit board, the circuit is liable to be subjected to stresses in a peeling direction, and it is necessary to select a material which can endure such peeling stresses. Accordingly, the multi-layer board material 7 using glass fiber woven fabric is preferable as a board material having higher peeling strength of outer layer circuit 9 rather than the compressibility of conductive paste 4.

Also, due to the high peeling strength, it is possible to obtain high-quality electrical connection between conductive paste 4 and outer layer circuit 9. Further, since glass fiber has extremely small moisture absorption, it is advantageous for preventing water invasion from outside of the circuit board.

As described above, in the preferred embodiment of the present invention, a configuration in that one sheet of inner layer board material 1 is used and prepregs and copper foils are disposed outside of the board material has been described. However, the present invention is not limited to the above configuration. That is, a configuration in that two sheet of double-sided circuit boards are prepared by using the multi-layer board material and one sheet or a plurality of sheets of inner layer board material prepreg is/are disposed between the circuit boards, or a configuration in that prepregs and copper foils are disposed at one side of a sheet of inner layer board material can be employed. And it is also possible to produce a multi-layered circuit board having less than four or more than four layers by combining the above-mentioned configurations.

Also, a configuration using a glass fiber non-woven fabric in an inner layer board material or using an aramid woven fabric in a multi-layer board material can be employed, and it is also possible to select other organic fiber materials and inorganic fiber materials as required.

Further, in the preferred embodiment described above, an example of laminating process for a board material having through-hole type via-holes 3 has been described, but the present invention is also effective in a case of blind-holes as being used for a circuit board in a buildup process or metal plating in place of conductive paste being used as a means for interstitial connection.

Also, in the present invention, the inner layer board material and the multi-layer board material are different in material composition from each other, and therefore, the process condition in the manufacturing process may be optimized in accordance with the respective board materials.

As an example, it is effective to optimize the conditions for pressing and curing the inner layer board material under heat and pressure and the conditions for curing the multi-layer board material under heat and pressure, that is, conditions such as heating temperatures, temperature increasing and decreasing rates, and pressing forces. For example, in the present preferred embodiment, since the glass woven fabric is used as reinforcing material for multi-layer board material, it is effective to decrease the temperature increasing rate to suppress the fluidity of impregnated resin.

According to the inventor's experiment, the temperature is raised from the room temperature to 180 °C at a rate of about 6 °C per minute for the inner layer board material, and at a speed of about 3 °C per minute for the multi-layer board material to obtain a favorable results.

### INDUSTRIAL APPLICABILITY

According to the circuit board and the method of manufacturing circuit board of the present invention, since the inner layer board material and multi-layer board material are different in material composition from each other, it is possible to improve the quality of interstitial electrical connection of the inner layer circuit board. Also, a mechanical strength such as the adhesive strength of the outermost layer circuit can be extremely improved because specific multi-layer board material is used for performing multi-layer lamination.

Also, according to the method of manufacturing circuit board of the present invention, the conditions such as for hot pressing in the laminating process can be set in a relatively wide range, which will bring about overall advantages with respect to the quality, reliability, and cost of the circuit board.

## Claims

1. A method of manufacturing a circuit board comprising:
an inner layer circuit board laminating step for laminating an inner layer board material (1) and at least one first metal sheet;
an inner layer circuit (6) forming step for forming circuits of said inner layer metal sheet to form an inner layer circuit board
a multi-layer laminating step for laminating at least one second metal sheet (8), at least one multi-layer board material and at least one of said inner layer circuit board so that said second metal sheet being laminated as an outermost layer,
said metal sheet contacting said multi-layer board material (7); and
a multi-layer circuit forming step for forming a circuit of said second metal sheet (8),
wherein said inner layer board material (1) includes a non-woven fabric reinforcing material and a resin material;
said multi-layer board material (7) includes a woven fabric reinforcing material and a resin material which includes uncured resin, and ;
said inner-layer board material (1) is provided with a plurality of interlayer connections, said interlayer connections being through-holes, which are filled with a conductive paste (4), within said inner-layer board material (1);
**characterized in that**
said multi-layer board material (7) is provided with a plurality of interlayer connections, each of which being a metal-plated layer formed in a blind-hole within said multi-layer board material (7) after said multi-layer laminating step.

2. The method of manufacturing circuit board of claim 1, wherein said multi-layer laminating step and said outer layer circuit forming step are repeated a plurality of times.

3. The method of manufacturing circuit board of claim 1, wherein at least one of said metal sheet for inner layer and said metal sheet for multi-layer is a metal foil.

4. A circuit board comprising a laminate, said laminate comprising:
at least one inner layer board material (1);
at least one inner layer circuit comprising a first metal sheet;
at least one multi-layer board materials (7), and
outer layer circuits comprising a second metal sheet (8) and being outermost layers of said laminate, said outer layer circuits contacting said multi-layer board materials (7);
wherein said inner layer board material (1) includes a non-woven fabric reinforcing material and a resin material;
said multi-layer board material(7) includes a woven fabric reinforcing material and a resin material which includes uncured resin; and
said inner-layer board material (1) includes a plurality of interlayer connections, said interlayer connections being through-hotes, which are filled with a conductive paste (4), within said inner-layer board material (1);
**characterized in that**
said multi-layer board material (7) includes a plurality of interlayer connections, each of which being a metal-plated layer formed in a blind-hole within said multi-layer board material(7).

## Patentansprüche

1. Verfahren zum Herstellen einer Leiterplatte, das umfasst:
einen Schritt des Laminierens einer Leiterplatte der inneren Schicht, mit dem ein Plattenmaterial (1) der inneren Schicht und wenigstens ein erstes Blech laminiert werden;
einen Schritt des Ausbildens von Schaltungen (6) der inneren Schicht, mit dem Schaltungen des Blechs der inneren Schicht ausgebildet werden, um eine Leiterplatte der inneren Schicht auszubilden;
einen Schritt des Laminieren mehrerer Schichten, mit dem wenigstens ein zweites Blech (8), wenigstens ein mehrschichtiges Plattenmaterial und wenigstens die Leiterplatte der inneren Schicht so laminiert werden, dass das zweite Blech als eine äußerste Schicht laminiert wird,
wobei das Blech mit dem mehrschichtigen Plattenmaterial (7) in Kontakt kommt; und einen Schritt des Ausbildens einer mehrschichtigen Schaltung, mit dem eine Schaltung des zweiten Blechs (8) ausgebildet wird,
wobei das Plattenmaterial (1) der inneren Schicht ein Vlies-Verstärkungsmaterial und ein Harzmaterial enthält;
das mehrschichtige Plattenmaterial (7) ein Gewebe-Verstärkungsmaterial und ein Harzmaterial enthält, das nicht gehärtetes Harz enthält; und
das Plattenmaterial (1) der inneren Schicht mit einer Vielzahl von ZwischenschichtVerbindungen versehen ist und die Zwischenschichtverbindungen mit einer leitenden Paste gefüllte Durchgangslöcher in dem Plattenmaterial (1) der inneren Schicht sind; **dadurch gekennzeichnet, dass**
das mehrschichtige Plattenmaterial (7) mit einer Vielzahl von Zwischenschicht-Verbindungen versehen ist, von denen jede eine metallplattierte Schicht ist, die in einem Blindloch in dem mehrschichtigen Plattenmaterial (7) nach dem Schritt des Laminierens mehrerer Schichten ausgebildet wird.

2. Verfahren zum Herstellen einer Leiterplatte nach Anspruch 1, wobei der Schritt des Laminierens mehrerer Schichten und der Schritt des Ausbildens der Schaltung der äußeren Schicht mehrmals wiederholt werden.

3. Verfahren zum Herstellen einer Leiterplatte nach Anspruch 1, wobei wenigstens das Blech für die innere Schicht oder das Blech für mehrere Schichten eine Metallfolie ist.

4. Leiterplatte, die ein Laminat umfasst, wobei das Laminat umfasst:
wenigstens ein Plattenmaterial (1) der inneren Schicht;
wenigstens eine Schaltung der inneren Schicht, die ein erstes Blech umfasst;
wenigstens ein mehrschichtiges Plattenmaterial (7), und
Schaltungen der äußeren Schicht, die ein zweites Blech (8) umfassen und äußerste Schichten des Laminats sind, wobei die Schaltungen der äußeren Schicht mit dem mehrschichtigen Plattenmaterial (7) in Kontakt sind;
wobei das Plattenmaterial (1) der inneren Schicht ein Vlies-Verstärkungsmaterial enthält;
das mehrschichtige Plattenmaterial (7) ein Gewebe-Verstärkungsmaterial und ein Harzmaterial enthält, das nicht gehärtetes Harz enthält; und
das Plattenmaterial (1) der inneren Schicht eine Vielzahl von Zwischenschicht-Verbindungen enthält und die Zwischenschichtverbindungen mit einer leitenden Paste (4) gefüllte Durchgangslöcher in dem Plattenmaterial (1) der inneren Schicht sind; **dadurch gekennzeichnet, dass**
das mehrschichtige Plattenmaterial (7) eine Vielzahl von Zwischenschicht-Verbindungen enthält, von denen jede eine metallplattierte Schicht ist, die in einem Blindloch in dem mehrschichtigen Plattenmaterial (7) ausgebildet ist.

## Revendications

1. Procédé de fabrication d'une carte de circuit imprimé comprenant:
une étape de stratification d'une carte de circuit imprimé à couches internes pour stratifier un matériau de carte à couches internes (1) et au moins une première feuille métallique;
une étape de formation de circuits de couches internes (6) pour former des circuits de ladite feuille métallique de couches internes afin de former une carte de circuit imprimé à couches internes;
une étape de stratification multicouche pour stratifier au moins une deuxième feuille métallique (8), au moins un matériau de carte multicouche et au moins l'une de ladite carte de circuit imprimé à couches internes de sorte que ladite deuxième feuille métallique soit stratifiée comme une couche la plus externe,
ladite feuille métallique rentrant en contact avec ledit matériau de carte multicouche (7); et
une étape de formation de circuit multicouche pour former un circuit de ladite deuxième feuille métallique (8),
où ledit matériau de carte à couches internes (I) inclut un matériau en renforcement de tissu non-tissé et un matériau de résine;
ledit matériau de carte multicouche (7) inclut un matériau de renforcement en tissu tissé et un matériau de résine qui inclut une résine non durcie, et;
ledit matériau de carte à couches internes (1) est doté d'une pluralité de connexions inter-couches, lesdites connexions inter-couches étant des trous traversants, qui sont remplis avec une pâte conductrice (4), dans ledit matériau de carte à couches internes (1);
**caractérisé en ce que**
ledit matériau de carte multicouche (7) est doté d'une pluralité de connexions inter-couches, chacune desquelles étant une couche à placage métallique formée dans un trou borgne dans ledit matériau de carte multicouche (7) après ladite étape de stratification multicouche.

2. Procédé de fabrication de carte de circuit imprimé de la revendication 1, dans lequel ladite étape de stratification multicouche et ladite étape de formation de circuits à couches externes sont répétées plusieurs fois.

3. Procédé de fabrication de carte de circuit imprimé de la revendication 1, dans lequel au moins l'une de ladite feuille métallique pour couche interne et de ladite feuille métallique pour multicouche est une tôle métallique.

4. Carte de circuit imprimé comprenant un stratifié, ledit stratifié comprenant:
au moins un matériau de carte à couches internes (1);
au moins un circuit de couches internes comprenant une première feuille métallique;
au moins un matériau de carte multicouche (7), et
des circuits de couches externes comprenant une deuxième feuille métallique (8) et qui sont les couches les plus externes dudit stratifié, lesdits circuits de couches externes rentrant en contact avec lesdits matériaux de carte multicouche (7);
où ledit matériau de carte à couches internes (1) inclut un matériau de renforcement en tissu non-tissé et un matériau de résine;
ledit matériau de carte multicouche (7) inclut un matériau de renforcement en tissu tissé et un matériau de résine qui inclut une résine non durcie; et
ledit matériau de carte à couches internes (1) inclut une pluralité de connexions inter-couches, lesdites connexions inter-couches étant des trous traversants, qui sont remplis avec une pâte conductrice (4), dans ledit matériau de carte à couches internes (1);
**caractérisé en ce que**
ledit matériau de carte multicouche (7) inclut une pluralité de connexions inter-couches, chacune desquelles étant une couche à placage métallique formée dans un trou borgne dans ledit matériau de carte multicouche (7).
